# EUROPÄISCHE PATENTSCHRIFT

(11) **EP 2 364 580 B1**
(45) Veröffentlichungstag und Bekanntmachung des Hinweises auf die Patenterteilung: **17.10.2012**
(21) Anmeldenummer: 09783520.1
(22) Anmeldetag: 29.09.2009
(51) Int. Cl.: H05K 7/14, H05K 7/20, H01L 23/473

(54) **STROMRICHTERMODUL MIT GEKÜHLTER VERSCHIENUNG**
RECTIFIER MODULE WITH COOLED BUSBAR
MODULE REDRESSEUR DE COURANT À SYSTÈME DE BARRES REFROIDI

(30) Priorität: 10.12.2008 DE 102008061468
(43) Veröffentlichungstag der Anmeldung: 14.09.2011
(73) Patentinhaber: Siemens Aktiengesellschaft, 80333 München (DE)
(72) Erfinder: HENTSCHEL, Stefan, 91085 Weisendorf (DE); PONATH, Harald, 96114 Hirschaid (DE)
(86) Internationale Anmeldenummer: PCT/EP2009/062579
(87) Internationale Veröffentlichungsnummer: WO 2010/066483

(56) Entgegenhaltungen:
- WO-A2-2004/079792
- DE-T5-112006 002 302
- JP-A- 2002 252 327
- US-A- 5 923 085

## Beschreibung

Die Erfindung bezieht sich auf ein Stromrichtermodul gemäß Oberbegriff des Anspruchs 1.

Gattungsgemäße Stromrichtermodule, insbesondere für höhere Leistungen, sind im Handel erhältlich. Bei derartigen Stromrichtermodulen sind dessen Leistungshalbleitermodule, insbesondere abschaltbare Leistungshalbleitermodule, mit Anschlüssen des Stromrichtermoduls niederinduktiv verschient. Dies wird dadurch erreicht, dass die verwendeten Stromschienen flächig ausgeführt und übereinander zu einem Stromschienenstapel gestapelt sind. Jeweils zwischen zwei flächigen Stromschienen ist eine flächig ausgeführte Isolierschicht angeordnet. Diese Isolierschichten überragen die flächigen Stromschienen, damit Grenzwerte für Luft- und Kriechstrecken eingehalten werden können. Somit weist eine derartige niederinduktive Verschienung mindestens zwei Stromschienen und mindestens eine Isolierschicht auf. Um die Verschienung der verwendeten Leistungshalbleitermodule des Stromrichtermoduls möglichst kompakt zu gestalten, ist dieses Schienenpaket laminiert. Durch die verwendeten Materialien, insbesondere das Laminiermaterial, und dem eingesetzten Kunststoff weist diese Verschienung eine Temperaturgrenze von beispielsweise 105° C auf.

Da bei den im Handel erhältlichen Leistungshalbleitermodulen, insbesondere abschaltbare Leistungshalbleitermodule, beispielsweise **I**nsulated-**G**ate-**B**ipolar-**T**ransistor (IGBT), die Stromtragfähigkeit stetig zunimmt, steigt dementsprechend die Stromdichte in den Stromschienen einer Verschienung, insbesondere einer laminierten Verschienung, eines Stromrichtermoduls an. Dies hat eine quadratische Zunahme der Verluste in der Verschienung zur Folge, so dass die Temperatur dieser Verschienung ebenfalls zunimmt und nicht über die Bodenplatte eines Halbleitermoduls respektive seinen Kühlkörper abgesenkt werden kann. Die Grenztemperatur einer Verschienung wird durch die eingesetzten Materialien der Isolierschichten, des Laminiermaterials und des Klebstoffs bestimmt. Bevorzugt kommen derzeit in Stromrichtermodulen mit Isolierfolie laminierte Verschienungen zum Einsatz. Hier setzt das Laminiermaterial der laminierten Verschienung eine Temperaturgrenze. Für Stromrichteranwendungen bedeutet dies eine Leistungsbegrenzung, die nicht mehr durch die eingesetzten Leistungshalbleitermodule, sondern durch die maximale Grenztemperatur des entsprechenden Laminiermaterials der Verschienung bedingt ist.

Naheliegende Lösungen dieses Problems sind einerseits, den Querschnitt einer jeden Stromschiene der Verschienung zu erhöhen, und andererseits diese Verschienung zu kühlen, beispielsweise durch Eigenkonvektion. Durch die Erhöhung der Querschnitte der Stromschienen der Verschienung ist eine derartige Verschienung nicht nur kostspieliger, sondern weist auch ein höheres Gewicht auf. Um die Verschienung durch Eigenkonvektion zu kühlen, muss diese in einem Stromrichtergerät derart angeordnet werden, dass ein Kühlluftstrom über diese Verschienung fließen kann.

Aus der WO 2005/109505 A1 ist eine Leistungshalbleiterschaltung bekannt, deren Verschienung gekühlt wird. Bei dieser Leistungshalbleiterschaltung ist wenigstens ein Modul auf einer als Plus- oder Minus-Platte dienenden plattenförmigen Stromschiene außenseitig aufgelötet. Die Plus- bzw. Minus-Schienen sind üblicherweise als oberste bzw. unterste Platte eines Platten-Verschienungspakets angeordnet. Diese Deckschiene, auf der das Modul aufgebracht ist, wird direkt von einer Kühleinrichtung gekühlt, wobei diese Kühleinrichtung als Luft- oder Flüssigkeitskühlung ausgebildet ist. Diese Kühleinrichtung ist sandwichartig zwischen der Deckschiene und unter Zwischenlage einer Isolierung einer weiteren, in einer parallelen Ebene liegenden plattenförmigen Stromschiene angeordnet. Ferner ist unter Zwischenlage einer weiteren Isolierschicht eine unterseitige Stromschiene vorgesehen. Diese Stromschienen bilden zusammen mit der Kühleinrichtung eine sehr kompakte Anordnung. Die Elemente dieses Verschienungspaketes sind durch Laminieren miteinander verbunden. Da es sich bei dieser Leistungshalbleiterschaltung um einen Wechselrichter handelt, sind unter diesem Verschienungspaket zwei Zwischenkreiskondensatoren angeordnet, die über Verschraubungen mit der oberen bzw. unteren Stromschiene verbunden sind.

Aus der DE 10 2007 003 875 A1 ist ein Stromrichtermodul mit wenigstens zwei Leistungshalbleitermodulen bekannt, die thermisch leitend mit einem Kühlkörper mechanisch verbunden und mittels einer laminierten Verschienung untereinander elektrisch verschaltet sind. Wenigstens eine Stromschiene dieser laminierten Verschienung ist mittels wenigstens eines elektrisch isolierenden und thermisch leitenden Stützelements mit dem Kühlkörper thermisch verknüpft. Durch diese Stützelemente ist wenigstens eine Stromschiene der laminierten Verschienung an den Kühlkörper thermisch angebunden. Die Höhe der abzuführenden Wärme bestimmt die Anzahl der thermisch leitenden Stützelemente. Mittels dieser Stützelemente wird die laminierte Verschienung in den Randbereichen ebenfalls abgestützt. Mittels dieser thermisch leitenden Stützelemente ist die Menge der von der laminierten Verschienung abzuführenden Wärmemenge beschränkt.

Aus der US 5 923 085 ist ein Stromrichtermodul mit zwei mittels einer Isolationsschicht voneinander isolierten Stromschienen bekannt, wobei die stromschienen jeweils einen Hohlraum aufweisen, der an einen Kühlkreislauf angeschlossen ist.

Der Erfindung liegt nun die Aufgabe zugrunde, ein Stromrichtermodul anzugeben, dessen Verschienung mit einfachen Mitteln entwärmt werden kann, wobei dieses Stromrichtermodul nicht neu entflechtet bzw. neu konstruiert werden muss.

Diese Aufgabe wird mit den kennzeichnenden Merkmalen des Anspruchs 1 erfindungsgemäß gelöst.

Dadurch, dass als Isolation zweier Stromschienen einer Verschienung eines Stromrichtermoduls zwei Isolierschichten vorgesehen sind, die derart miteinander stoffschlüssig verbunden sind, dass zwischen diesen beiden Isolierschichten ein Hohlraum entsteht, der ein- und ausgangsseitig in wenigstens einer Seitenfläche dieser Isolationsschicht mündet, können die beiden an dieser Isolationsschicht anliegenden Stromschienen gekühlt werden. Mittels zweier Stutzen und zweier Schläuche ist diese Isolationsschicht flüssigkeitsmäßig mit einem Kühlkreislauf des Flüssigkeits-Kühlkörpers des Stromrichtermoduls verbindbar. Durch die Kühlung der Isolationsschicht zweier Stromschienen einer Verschienung wird die Grenztemperatur heraufgesetzt, so dass nun das Leistungsvermögen des Stromrichtermoduls wieder vom Leistungsvermögen der verwendeten Leistungshalbleitermodule bestimmt wird.

Bei einer vorteilhaften Ausführungsform des Stromrichtermoduls ist wenigstens eine Isolierschicht der Isolationsschicht der Verschienung als Formteil ausgebildet, das eine vorbestimmt geformte Rinne aufweist. Durch die Verwendung wenigstens einer als Formteil ausgebildeten Isolierschicht ist die Herstellung einer Isolationsschicht mit Hohlraum wesentlich einfacher.

Sind beide Isolierschichten der Isolationsschicht der Verschienung jeweils als Formteil ausgebildet, so sind diese beiden Isolierschichten spiegelsymmetrisch zueinander ausgebildet. Nachdem diese beiden Isolierschichten miteinander stoffschlüssig verbunden sind, erhält man eine Isolationsschicht mit einem Hohlraum, mit der eine Verschienung flüssigkeitsgekühlt werden kann.

Bei einer vorteilhaften Ausführungsform des Stromrichtermoduls sind die Stromschienen und wenigstens eine Isolationsschicht der Verschienung des Stromrichtermoduls miteinander laminiert. Dadurch bildet diese Verschienung eine mechanische Einheit und kann wie eine handelsübliche laminierte Verschienung gehandhabt werden.

Bei einer weiteren vorteilhaften Ausführungsform des Stromrichtermoduls ist der Hohlraum schlauchartig ausgebildet und verläuft zwischen den beiden Isolierschichten mäanderförmig. Dadurch entspricht dieser Hohlraum zwischen den beiden Isolierschichten funktionsmäßig einem Schlauch, durch den ein Kühlmittel, insbesondere Leitungswasser, geführt werden kann. Durch die mäanderförmige Verlegung dieses Hohlraums zwischen den beiden Isolierschichten kann annähernd die gesamte Fläche dieser Isolationsschicht entwärmt werden.

Bei einer weiteren vorteilhaften Ausführungsform des Stromrichtermoduls ist der schlauchartige Hohlraum zwischen den beiden Isolierschichten flüssigkeitsmäßig parallel zum Kühlkreislauf des Flüssigkeits-Kühlkörpers geschaltet. Dazu weist der Hohlraum ein- und ausgangsseitig jeweils einen Stutzen auf, dessen Ende mit einem Schlauch versehen ist. Durch die Versorgung der Isolationsschicht der Verschienung des Stromrichtermoduls aus einem Flüssigkeits-Kühlkörper bleiben die Anschlüsse, insbesondere die Kühlmittel-Anschlüsse, des Stromrichtermoduls unverändert.

Bei einer weiteren vorteilhaften Ausführungsform des Stromrichtermoduls weist der Hohlraum abschnittsweise unterschiedliche Querschnitte auf. Durch die Variation des Hohlraumquerschnittes in Form und Größe der Querschnittsfläche kann die Fließgeschwindigkeit der Kühlflüssigkeit für bestimmte Bereiche wenigstens einer Stromschiene vorbestimmt beeinflusst werden.

Zur weiteren Erläuterung der Erfindung wird auf die Zeichnung Bezug genommen, in der eine Ausführungsform schematisch veranschaulicht ist.
- FIG 1: zeigt ein handelsübliches Stromrichtermodul, in der
- FIG 2: ist eine Verschienung eines Stromrichtermoduls nach der FIG 1 dargestellt und in der
- FIG 3: ist eine erfindungsgemäße Isolation einer Verschienung nach FIG 2 dargestellt.

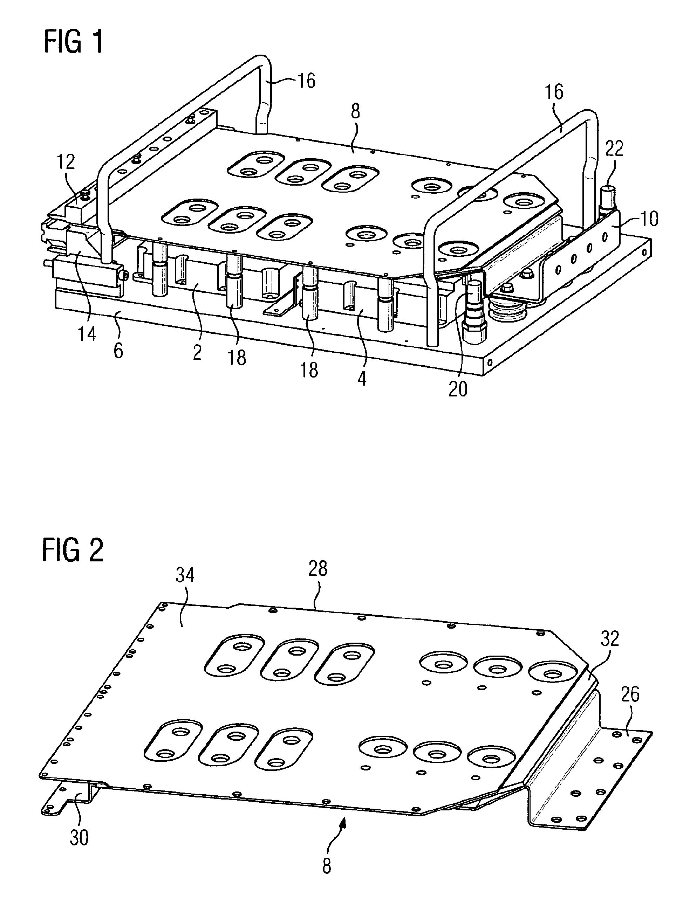

In der Figur 1, die eine perspektivische Sicht eines im Handel erhältlichen Stromrichtermoduls darstellt, sind mit 2 und 4 jeweils ein Leistungshalbleitermodul, insbesondere ein abschaltbares Leistungshalbleitermodul, beispielsweise ein Insulated-Gate-Bipolar-Transistor (IGBT), mit 6 ein Flüssigkeits-Kühlkörper, mit 8 eine Verschienung, mit 10 ein wechselspannungsseitiger Anschluss, mit 12 und 14 jeweils ein gleichspannungsseitiger Anschluss, mit 16 ein Bügel und mit 18 Stützelemente bezeichnet. Außerdem sind in dieser Darstellung ein Kühlmittelzu- und -ablauf mit 20 und 22 bezeichnet.

Die beiden Leistungshalbleitermodule 2 und 4 sind mechanisch mit dem Flüssigkeits-Kühlkörper 6 lösbar befestigt. Die Verschienung 8 kann zwei Stromschienen, beispielsweise eine Plus-Stromschiene und eine Last-Stromschiene bzw. eine Last-Stromschiene und eine Minus-Stromschiene, oder drei Stromschienen, beispielsweise eine Plus-, Last- und Minusstromschiene, aufweisen. Die Anzahl der Stromschienen der Verschienung 8 hängt von der elektrischen Verschaltung der beiden Leistungshalbleitermodule 2 und 4 ab. Sind diese beiden Leistungshalbleitermodule 2 und 4 elektrisch parallel geschaltet, so weist die Verschienung 8 nur zwei Stromschienen auf. Sind dagegen diese beiden Leistungshalbleitermodule 2 und 4 elektrisch in Reihe geschaltet und bilden ein Phasenmodul eines Stromrichters, so weist die Verschienung 8 drei Stromschienen auf. Wird das Stromrichtermodul als Phasenmodul verwendet, so sind die drei Stromschienen der Verschienung 8 eine Plus-, Last- und Minusstromschiene. Diese Stromschienen sind übereinander angeordnet, wobei jeweils zwischen zwei Stromschienen eine Isolierschicht angeordnet, und laminiert.

Diese Verschienung 8 ist auf die elektrischen Anschlüsse eines jeden Leistungshalbleitermoduls 2 und 4 angeordnet. Bei diesen elektrischen Anschlüssen kann es sich um Lötstifte, Käfigmuttern oder Schraubbolzen handeln. Ab einem vorbestimmten Leistungsvermögen des Leistungshalbleitermoduls 2, 4 weisen die Leistungshalbleitermodule 2, 4 als elektrische Anschlüsse nur noch Käfigmuttern zur Befestigung von Schraubbolzen auf. Entsprechend der Verschaltung der beiden Leistungshalbleitermodule 2, 4 sind deren Anschlüsse jeweils mit einer vorbestimmten Stromschiene der Verschienung 8 elektrisch leitend verbunden. Diese Verschienung 8 stützt sich nicht nur auf die Anschlüsse der Leistungshalbleitermodule 2, 4, sondern auch auf eine Mehrzahl von Stützelementen 18 ab. Diese sind entlang jeweils einer Längsseite des Stromrichtermoduls angeordnet. An den Stirnseiten der Verschienung wird diese Verschienung zusammen mit den Anschlüssen 12, 14 und 10 gehalten.

Da als Kühlkörper dieses Stromrichtermoduls ein Flüssigkeits-Kühlkörper 6 vorgesehen ist, weist dieser einen Kühlmittelzulauf 20 und einen Kühlmittelablauf 22 auf. Mit diesen Kühlmittelzu- und -abläufen 20 und 22 ist das Stromrichtermodul mit einem Kühlmittelkreislauf flüssigkeitsmäßig verbunden. Als Kühlflüssigkeit kann jede Flüssigkeit, insbesondere Leitungswasser, verwendet werden.

Da die Stromtragfähigkeit der im Stromrichtermodul verwendeten Leistungshalbleitermodule 2, 4 stetig zunimmt, steigt auch der Strom in den Stromschienen der Verschienung 8, insbesondere einer laminierten Verschienung 8, an. Dies hat eine quadratische Zunahme der Verluste in der Verschienung 8 zur Folge. Dadurch steigt die Temperatur in der Verschienung 8 an. Wie hoch die Grenztemperatur der Verschienung 8 sein kann, hängt von den verwendeten Materialien ab. Das heißt, das Isoliermaterial, insbesondere das Laminiermaterial, der Verschienung 8 setzt die Temperaturgrenze fest. Das bedeutet für Stromrichteranwendungen eine Leistungsbegrenzung, die nicht mehr durch die eingesetzten Leistungshalbleitermodule 2, 4, sondern durch die materialspezifische Grenztemperatur eines Isolier- bzw. Laminiermaterials bestimmt wird.

Wegen der Übersichtlichkeit ist in der FIG 2 nur die Verschienung 8 des Stromrichtermoduls nach Figur 1 perspektivisch dargestellt, wobei die Elemente der Verschienung 8 noch nicht miteinander laminiert sind. Wie bereits erwähnt, weist ein Stromrichtermodul als Fhasenbaustein eines mehrphasigen Stromrichters zwei Leistungshalbleitermodule 2 und 4 auf, die elektrisch in Reihe geschaltet sind. Der Verbindungspunkt dieser Reihenschaltung zweier Leistungshalbleitermodule 2 und 4 bildet einen wechselspannungsseitigen Anschluss 10, insbesondere einen Last-Anschluss. Mit diesem Last-Anschluss 10 ist eine Stromschiene 26, auch bezeichnet als Laststromschiene, der Verschienung 8 elektrisch leitend verbunden. Die gleichspannungsseitigen Anschlüsse 12 und 14 des Stromrichtermoduls sind jeweils mit einer Stromschiene 28 bzw. 30 elektrisch leitend verbunden, die auch als Plus- bzw. Minusstromschiene bezeichnet werden. Diese Stromschienen 26, 28 und 30 sind räumlich übereinander angeordnet, wobei jeweils zwischen zwei benachbarten Stromschienen 26, 28 bzw. 28, 30 eine Isolationsschicht 32 angeordnet ist. Somit weist eine handelsübliche Verschienung eines Phasenmoduls wenigstens fünf Lagen auf. Damit diese Lagen zueinander mechanisch fixiert sind, ist dieser Stapel von drei Stromschienen 26, 28 und 30 und wenigstens zwei Isolationsschichten 32 miteinander laminiert. Dadurch werden außerdem die geforderten Luft- und Kriechstrecken eingehalten.

In der perspektivischen Darstellung gemäß FIG 2 weist die Verschienung 8 nur drei Lagen auf, nämlich eine untere Lage, in der die Minus- und die Laststromschiene 30 und 26 nebeneinander angeordnet sind, eine Isolierlage, in der die Isolierschicht 32 angeordnet ist, und eine obere Lage, in der die Plusstromschiene 28 angeordnet ist. Auf der Oberfläche 34 der oberen bzw. unteren Stromschiene 28 bzw. 30 der Verschienung 8 ist keine zusätzliche Isolierschicht angeordnet. Die Isolierung dieser Oberflächen 34 wird vom Laminat übernommen.

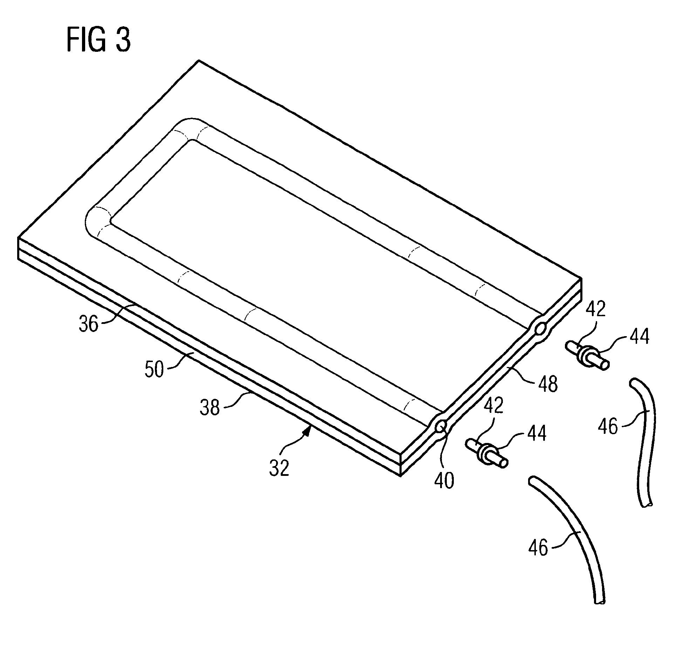

Um die in der laminierten Verschienung 8 entstandene Verlustleistung abführen zu können, ist die Isolationsschicht 32 der Verschienung 8 mit einem Hohlraum 40 versehen (FIG 3). Dieser Hohlraum 40 ist kühlmittelmäßig mit dem Flüssigkeitskreislauf des Flüssigkeits-Kühlkörpers 6 verbunden. Der Flüssigkeitskreislauf des Flüssigkeits-Kühlkörpers 6 wird als Primärkreislauf und der Flüssigkeitskreislauf des Hohlraums 40 als Sekundärkreislauf bezeichnet. Der Primär- und der Sekundärkreislauf können flüssigkeitsmäßig parallel oder in Reihe geschaltet sein.

Gemäß der Erfindung ist wenigstens eine Isolationsschicht 32 der Verschienung 8 des Stromrichtermoduls mit einem Hohlraum 40 versehen. Eine erfindungsgemäße Isolationsschicht 32 ist in FIG 3 perspektivisch dargestellt. Diese Isolationsschicht 32 weist zwei Isolierschichten 36 und 38 auf, die stoffschlüssig miteinander verbunden sind. Dabei sind diese beiden Isolierschichten 36 und 38 derart miteinander stoffschlüssig verbunden, dass ein Hohlraum 40 entsteht. Damit dieser Hohlraum 40 eine gewünschte Querschnittsfläche aufweist, wird in diesem Hohlraum 40 Druckluft eingeführt. Dadurch wird dieser Hohlraum 40 aufgeblasen. Damit die Querschnittsfläche des Hohlraums 40 über seine gesamte Länge annähernd konstant ist, sind diese beiden stoffschlüssig miteinander verbundenen Isolierschichten 36 und 38 in einer Form eingelegt. Eine vorteilhafte Querschnittsfläche des Hohlraums 40 ist rechteckförmig, da dadurch zwei beidseitig angeordnete Stromschienen 28, 30 nicht wesentlich weiter voneinander beabstandet sind.

Um einen derartigen Hohlraum 40 zu erhalten, kann wenigstens eine der beiden Isolierschichten 36 oder 38 als Formteil ausgebildet sein, das eine vorbestimmt geformte Rinne aufweist. Sind beide Isolierschichten 36 und 38 als Formteil ausgebildet, so sind diese zueinander spiegelsymmetrisch aufgebaut. Diese beiden Formteile werden ebenfalls stoffschlüssig miteinander verbunden. In dem dargestellten Ausführungsbeispiel (FIG 3) ist jede Rinne einer als Formteil ausgebildeten Isolierschicht 36 und 38 halbkreisförmig. Da diese beiden als Formteil ausgebildeten Isolierschichten 36 und 38 spiegelsymmetrisch aufgebaut sind, entsteht durch eine stoffschlüssige Verbindung dieser beiden Isolierschichten 36 und 38 eine Isolationsschicht 32 mit dem dargestellten Hohlraum 40.

Damit dieser Hohlraum 40 Kühlflüssigkeit durch diese Isolationsschicht 32 führen kann, muss dieser an einen Kühlkreislauf flüssigkeitsmäßig angeschlossen werden. Dazu sind zwei Stutzen 42 und zwei Schläuche 46 vorgesehen. Jeder Stutzen 32 weist mittig einen ringförmigen Flansch 44 auf. Von diesem ringförmigen Flansch 44 verläuft jedes Ende des Stutzens 42 verjüngend. Dadurch kann einerseits dieser Stutzen 42 ohne großen Aufwand in eine Öffnung des Hohlraums 40 gesteckt werden und andererseits kann ohne großen Aufwand der Schlauch 46 auf das noch freie Ende des Stutzens 42 gesteckt werden. Im montierten Zustand des Stutzens 42 stützt sich der ringförmige Flansch 44 auf eine Seitenfläche der Isolationsschicht 32 ab. Im dargestellten Beispiel stützt sich der ringförmige Flansch 44 eines jeden Stutzen 42 auf die Stirnfläche 48 der Isolationsschicht 32 ab. In der Darstellung der Isolationsschicht 32 gemäß FIG 3 verläuft der entstandene Hohlraum 40 U-förmig in der Isolationsschicht 32. Das heißt, beide Enden dieses Hohlraums 40 münden in der Stirnfläche 48 der Isolationsschicht 32. Um die Isolationsschicht 32 großflächig zu entwärmen, muss der entstandene Hohlraum 40 mäanderförmig zwischen den beiden Enden in der Stirnseite 48 der Isolationsschicht 32 verlaufen. Es ist auch möglich, dass die beiden Enden des Hohlraums 40 in gegenüberliegenden Stirnflächen 48 der Isolationsschicht 32 münden. Es ist auch vorstellbar, dass die beiden Enden des Hohlraums 40 jeweils in einer Schmalfläche 50 oder in einer Schmalfläche 50 und einer Stirnfläche 48 münden. Der Kühlkreislauf, der vom Hohlraum 40 festgelegt ist, wird als Sekundärkreislauf bezeichnet. Demgegenüber wird der Kühlkreislauf des Flüssigkeits-Kühlkörpers 6 als Primärkreislauf bezeichnet. Diese beiden Kühlkreisläufe können nun flüssigkeitsmäßig parallel oder in Reihe geschaltet werden. Vorteilhaft ist die Parallelschaltung des Sekundärkreislaufs zum Primärkreislauf, da dann beide Kreisläufe mit nicht vorbelastetem Kühlmittel versorgt werden.

Durch diese erfindungsgemäß ausgebildete Isolationsschicht 32, die mit Stromschienen 26, 28 und 30 zu einer Verschienung 8 gestapelt und laminiert sind, kann die Verschienung 8 derart entwärmt werden, dass die Leistung des Stromrichtermoduls wieder vom Leistungsvermögen der verwendeten Leistungshalbleitermodule 2 und 4 und nicht mehr von einer Grenztemperatur des verwendeten Laminiermaterials bestimmt wird. Somit kann das erfindungsgemäße Stromrichtermodul gegenüber einem handelsüblichen Stromrichtermodul höher elektrisch ausgelastet werden, wobei die zulässige Temperatur für die Isolationsschicht 32 und das Laminiermaterial eingehalten werden kann.

## Patentansprüche

1. Stromrichtermodul mit wenigstens zwei Leistungshalbleitermodulen (2, 4), die thermisch leitend mit einem Flüssigkeits-Kühlkörper (6) mechanisch verbunden sind und die mittels einer Verschienung (8), die wenigstens zwei mittels einer Isolationsschicht (32) voneinander isolierte Stromschienen (26, 28; 28, 30) aufweist, mit Anschlüssen (10, 12, 14) des Stromrichtermoduls elektrisch leitend verknüpft sind, **dadurch gekennzeichnet, dass** die Isolationsschicht (32) zwei Isolierschichten (36, 38) aufweist, die derart stoffschlüssig miteinander verbunden sind, dass zwischen diesen beiden Isolierschichten (36, 38) ein vorbestimmt geformter Hohlraum (40) vorhanden ist, der ein- und ausgangsseitig in wenigstens einer Seitenfläche (48, 50) dieser Isolationsschicht (32) mündet, und dass dieser Hohlraum (40) ein- und ausgangsseitig jeweils mit einem Stutzen (42) versehen ist, die jeweils flüssigkeitsmäßig mit dem Flüssigkeits-Kühlkörper (6) verbunden sind.

2. Stromrichtermodul nach Anspruch 1, **dadurch gekennzesichnet**, dass wenigstens eine Isolierschicht (36,38) derart als Formteil ausgebildet ist, dass diese eine vorbestimmt geformte Rinne aufweist.

3. Stromrichtermodul nach Anspruch 1, **dadurch gekennzeichnet, dass** die beiden als Formteile ausgebildeten Isolierschichten (36,38) spiegelsymmetrisch aufgebaut sind.

4. Stromrichtermodul nach Anspruch 1, **dadurch gekennzeichnet, dass** die Stromschienen (26, 28, 30) und wenigstens eine Isolationsschicht (32) miteinander laminiert sind.

5. Stromrichtermodul nach einem der vorgenannten Ansprüche, **dadurch gekennzeichnet, dass** der Hohlraum (40) schlauchartig ausgebildet ist.

6. Stromrichtermodul nach einem der vorgenannten Ansprüche, **dadurch gekennzeichnet, dass** der Hohlraum (40) mäanderförmig verläuft.

7. Stromrichtermodul nach einem der vorgenannten Ansprüche, **dadurch gekennzeichnet, dass** der Stutzen (42) einen ringförmigen Flansch (44) aufweist.

8. Stromrichtermodul nach Anspruch 7, **dadurch gekennzeichnet, dass** die beiden Enden der Stutzen (42) vom ringförmigen Flansch (44) verjüngend verlaufen.

9. Stromrichtermodul nach einem der vorgenannten Ansprüche, **dadurch gekennzeichnet, dass** der Hohlraum (40) flüssigkeitsmäßig parallel zum Kühlkreislauf des Flüssigkeits-Kühlkörpers (6) geschaltet ist.

10. Stromrichtermodul nach einem der Ansprüche 1 bis 8, **dadurch gekennzeichnet, dass** der Hohlraum (40) flüssigkeitsmäßig in Reihe zum Kühlkreislauf des Flüssigkeits-Kühlkörpers (6) geschaltet ist.

11. Stromrichtermodul nach einem der vorgenannten Ansprüche, **dadurch gekennzeichnet, dass** der Hohlraum (40) eine kreisförmige Querschnittsfläche aufweist.

12. Stromrichtermodul nach einem der Ansprüche 1 bis 10, **dadurch gekennzeichnet, dass** der Hohlraum (40) eine rechteckförmige Querschnittsfläche aufweist.

13. Stromrichtermodul nach Anspruch 2, **dadurch gekennzeichnet, dass** die Rinne V-förmig ausgebildet ist.

14. Stromrichtermodul nach Anspruch 2, **dadurch gekennzeichnet, dass** die Rinne halbkreisförmig ausgebildet ist.

15. Stromrichtermodul nach Anspruch 2, **dadurch gekennzeichnet, dass** die Rinne U-förmig ausgebildet ist.

16. Stromrichtermodul nach Anspruch 2, **dadurch gekennzeichnet, dass** der Hohlraum (40) abschnittesweise unterschiedliche Querschnittsflächen aufweist.

## Claims

1. Power converter module comprising at least two power semiconductor modules (2, 4) which are mechanically connected to a liquid cooling body (6) in a thermally conductive manner and which are electrically conductively linked to connections (10, 12, 14) of the power converter module by means of a busbar arrangement (8) having at least two busbars (26, 28; 28, 30) insulated from one another by means of an insulation layer (32), **characterized in that** the insulation layer (32) has two insulating layers (36, 38), which are connected to one another cohesively in such a way that a cavity (40) shaped in a predetermined manner is present between said two insulating layers (36, 38), said cavity opening on the entrance and exit side in at least one side surface (48, 50) of said insulation layer (32), and that said cavity (40) is respectively provided with a connector (42) on the entrance and exit side, which connectors are in each case connected in terms of liquid to the liquid cooling body (6).

2. Power converter module according to Claim 1, **characterized in that** at least one insulating layer (36, 38) is embodied as a shaped part in such a way that it has a groove shaped in a predetermined manner.

3. Power converter module according to Claim 1, **characterized in that** the two insulating layers (36, 38) embodied as shaped parts are constructed mirror-symmetrically.

4. Power converter module according to Claim 1, **characterized in that** the busbars (26, 28, 30) and at least one insulation layer (32) are laminated with one another.

5. Power converter module according to any of the preceding claims, **characterized in that** the cavity (40) is embodied in a hose-like manner.

6. Power converter module according to any of the preceding claims, **characterized in that** the cavity (40) runs in a meandering fashion.

7. Power converter module according to any of the preceding claims, **characterized in that** the connector (42) has a ring-shaped flange (44).

8. Power converter module according to Claim 7, **characterized in that** the two ends of the connectors (42) run in a tapering manner from the ring-shaped flange (44).

9. Power converter module according to any of the preceding claims, **characterized in that** the cavity (40), in liquid terms, is connected in parallel with the cooling circuit of the liquid cooling body (6).

10. Power converter module according to any of Claims 1 to 8, **characterized in that** the cavity (40), in liquid terms, is connected in series with the cooling circuit of the liquid cooling body (6).

11. Power converter module according to any of the preceding claims, **characterized in that** the cavity (40) has a circular cross-sectional area.

12. Power converter module according to any of Claims 1 to 10, **characterized in that** the cavity (40) has a rectangular cross-sectional area.

13. Power converter module according to Claim 2, **characterized in that** the groove is embodied in a V-shaped manner.

14. Power converter module according to Claim 2, **characterized in that** the groove is embodied in a semicircular manner.

15. Power converter module according to Claim 2, **characterized in that** the groove is embodied in a U-shaped manner.

16. Power converter module according to Claim 2, **characterized in that** the cavity (40) has different cross-sectional areas in sections.

## Revendications

1. Module redresseur de courant ayant au moins deux modules (2, 4) à semiconducteur de puissance, qui sont reliés mécaniquement avec conduction de la chaleur à un dissipateur ( 6 ) de chaleur à liquide et qui sont combinés de manière conductrice de l'électricité au moyen d'un ensemble ( 8 ) de barres, qui comporte au moins deux barres ( 26, 28; 28, 30 ) de courant isolées l'une de l'autre au moyen d'une couche ( 32 ) isolante, à des bornes ( 10, 12, 14 ) du module de convertisseur de courant, **caractérisé en ce que** la couche ( 32 ) isolante comporte deux couches ( 36, 38 ) isolantes, qui sont reliées l'une à l'autre à complémentarité de matière, de manière à ce qu'il y ait entre ces deux couches ( 36, 38 ) isolantes une cavité ( 40 ), qui est conformée de manière déterminée à l'avance et qui débouche du côté de l'entrée et du côté de la sortie dans au moins une surface ( 48, 50 ) latérale de cette couche ( 32 ) isolante et **en ce que** cette cavité ( 40 ) est pourvue du côté de l'entrée et du côté de la sortie respectivement d'une tubulure ( 42 ), qui communique respectivement fluidiquement avec le dissipateur ( 6 ) de chaleur à liquide.

2. Module redresseur de courant suivant la revendication 1, **caractérisé en ce que** au moins une couche ( 36, 38 ) isolante est constituée en pièce moulée, de manière à ce que celle-ci ait une goulotte conformée de manière déterminée à l'avance.

3. Module redresseur de courant suivant la revendication 1, **caractérisé en ce que** les deux couches ( 36, 38 ) isolantes formées de pièce moulée sont symétriques comme en un miroir.

4. Module redresseur de courant suivant la revendication 1, **caractérisé en ce que** les barres ( 26, 28, 30 ) de courant et au moins une couche ( 32 ) isolante sont laminées entre elles.

5. Module redresseur de courant suivant l'une des revendications précédentes, **caractérisé en ce que** la cavité ( 40 ) est constituée à la manière d'un tube souple.

6. Module redresseur de courant suivant l'une des revendications précédentes, **caractérisé en ce que** la cavité ( 40 ) est sinueuse.

7. Module redresseur de courant suivant l'une des revendications précédentes, **caractérisé en ce que** la tubulure ( 42 ) a une bride ( 44 ) annulaire.

8. Module redresseur de courant suivant la revendication 7, **caractérisé en ce que** les deux extrémités de la tubulure ( 42 ) s'étendent en se rétrécissant à partir de la bride ( 44 ) annulaire.

9. Module redresseur de courant suivant l'une des revendications précédentes, **caractérisé en ce que** la cavité ( 40 ) est montée, du point de vue du liquide, en parallèle au circuit de refroidissement du dissipateur ( 6 ) de chaleur à liquide.

10. Module redresseur de courant suivant l'une des revendications 1 à 8, **caractérisé en ce que** la cavité ( 40 ) est montée, du point de vue du liquide, en série avec le circuit de refroidissement du dissipateur ( 6 ) de chaleur à liquide.

11. Module redresseur de courant suivant l'une des revendications précédentes, **caractérisé en ce que** la cavité ( 40 ) a une surface de section transversale circulaire.

12. Module redresseur de courant suivant l'une des revendications 1 à 10, **caractérisé en ce que** la cavité ( 40 ) a une surface de section transversale rectangulaire.

13. Module redresseur de courant suivant la revendication 2, **caractérisé en ce que** la goulotte est en forme de V.

14. Module redresseur de courant suivant la revendication 2, **caractérisé en ce que** la goulotte est de forme hémicirculaire.

15. Module redresseur de courant suivant la revendication 2, **caractérisé en ce que** la goulotte est en forme de U.

16. Module redresseur de courant suivant la revendication 2, **caractérisé en ce que** la cavité ( 40 ) a par endroit des surfaces de section transversale différentes.
